(19)

Europäisches
Patentamt
European
Patent Office
Office européen
des brevets

(11)　EP 2 512 029 A1

(12)　EUROPEAN PATENT APPLICATION

(43) Date of publication:
17.10.2012　Bulletin 2012/42

(51) Int Cl.:
H03F 3/20 (2006.01)　　H04R 19/02 (2006.01)

(21) Application number: 11161836.9

(22) Date of filing: 11.04.2011

(84) Designated Contracting States:
AL AT BE BG CH CY CZ DE DK EE ES FI FR GB
GR HR HU IE IS IT LI LT LU LV MC MK MT NL NO
PL PT RO RS SE SI SK SM TR
Designated Extension States:
BA ME

(71) Applicant: ABC Taiwan Electronics Corp.
Taoyuan-Hsien
32627 (TW)

(72) Inventors:
• Fan, LiangFang
32627, Taoyuan (TW)
• Hsiao, MingChien
32627, Taoyuan (TW)
• Chen, TangKang
32627, Taoyuan (TW)

(74) Representative: Schwerbrock, Florian
Danziger Straße 35a
20099 Hamburg (DE)

(54)　**Audio signal driver for flat sound generator**

(57)　An audio driver for a flat sound generator is coupled to the sound generator. The audio driver includes a power amplifier and an audio-amplifying transformer, the power amplifier receiving an input audio signal and the audio-amplifying transformer transforms the input audio signal into an output audio signal to drive a flat sound generator. The flat sound generator includes a perforated electrode plate and a diaphragm. Wherein, the audio-amplifying transformer and the flat sound generator form a low-pass filter effectively.

FIG. 2

EP 2 512 029 A1

**Description**

BACKGROUND

With the advancement of the technology, the requirement of the low power consumption becomes more important. As a result, the size of the portable electronic device is become thinner and thinner. Because of the disadvantage of the big volume and the weight of the flat sound generator system of the portable electronic device applied for the conventional sound generator, the power consumption of the driver of the flat sound generator system is around 1.5W-2W and that it's about 20%~70% of the whole power consumption. The power consumption rate of the driver is too high for the portable electronic device. Thus, more and more efforts are focus on the improvement of the flat sound generator system.

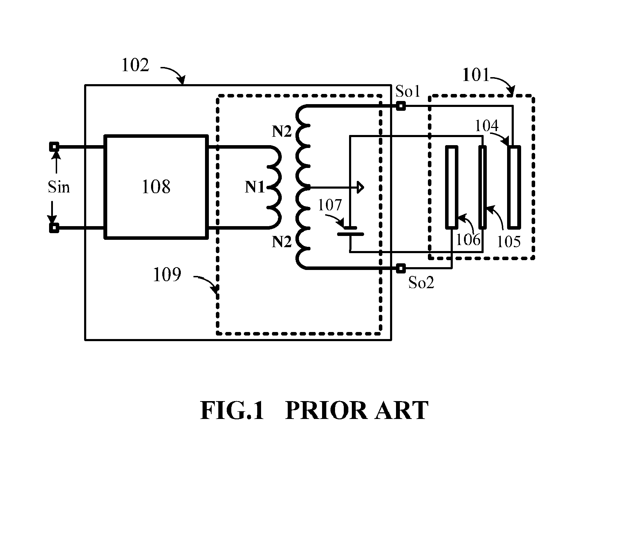

FIG. 1 illustrates a conventional audio driver of a flat sound generator system. The audio driver 102 coupled to a flat sound generator system 101. The audio driver 102 includes an audio amplifier 108 and a high power transformer with low bandwidth 109, the audio driver 102 is used for receiving an input audio signal $S_{in}$ and for transforming it into two high voltage output audio signals $S_{o1}$ and $S_{o2}$, wherein the output audio signals $S_{o1}$ and $S_{o2}$ have the same intensity with each other but one is positive high voltage and the other is negative. The flat sound generator system 101 includes two electrodes 106 and 104 and a thin film 105 which located between the electrodes 106 and 104. The electrodes 106 and 104 can be a grid or a stator. The thin film 105 receives a DC high voltage 107. When two output audio signals $S_{o1}$ and $S_{o2}$ applied to the electrodes 106 and 104 respectively, the thin film 105 be attracted or repelled by the electrodes 106 and 104 so as to vibrate and sounded.

Since the conventional flat sound generator system make sounds by utilizing high voltage signals, thus, the audio driver 102 has to utilize the high power transformer with low bandwidth 109 so as to transform the signal which generated by the audio amplifier 108 into two output audio signals $S_{o1}$ and $S_{o2}$ which flat sound generator system 101 needed. However, in order to avoid the signal distorted within the whole audio frequency range, the size of the coil inductor and the core of the high power transformer with low bandwidth 109 need bigger. It may occupy large space and expensive. In other words, the issue of the size of the coil inductor and the core will cause the volume and the weight of the flat sound generator system 101 can not be reduced efficiency.

Consequently, it is so important to reduce the volume and the weight of the flat sound generator system effectively and decrease the power consumption of the flat sound generator system, so as to improve the working time of the portable electronic device.

SUMMARY

In one embodiment, an audio driver for a flat sound generator is coupled to the sound generator. The audio driver includes a power amplifier and an audio-amplifying transformer, the power amplifier receiving an input audio signal and the audio-amplifying transformer transforms the input audio signal into an output audio signal to drive a flat sound generator. The flat sound generator includes a perforated electrode plate and a diaphragm. Wherein, the audio-amplifying transformer and the flat sound generator form a low-pass filter effectively.

BRIEF DESCRIPTION OF THE DRAWINGS

Features and advantages of embodiments of the claimed subject matter will become apparent as the following detailed description proceeds, and upon reference to the drawings, wherein like numerals depict like parts, and in which:

FIG. 1 illustrates a conventional audio driver of a flat sound generator system.

FIG. 2 illustrates an audio driver for flat sound generator system in accordance with one embodiment of the present invention.

FIG. 3 illustrates an audio driver for flat sound generator system in accordance with another embodiment of the present invention.

DETAILED DESCRIPTION

Reference will now be made in detail to the embodiments of the present invention, examples of which are illustrated in the accompanying drawings. While the invention will be described in conjunction with the embodiments, it will be understood that they are not intended to limit the invention to these embodiments. On the contrary, the invention is intended to cover alternatives, modifications and equivalents, which may be included within the spirit and scope of the invention as defined by the appended claims.

Furthermore, in the following detailed description of embodiments of the present invention, numerous specific details are set forth in order to provide a thorough understanding of the present invention. However, it will be recognized by one of ordinary skill in the art that the present invention may be practiced without these specific details. In other instances, well-known methods, procedures, components, and circuits have not been described in detail as not to unnecessarily obscure aspects of the embodiments of the present invention.

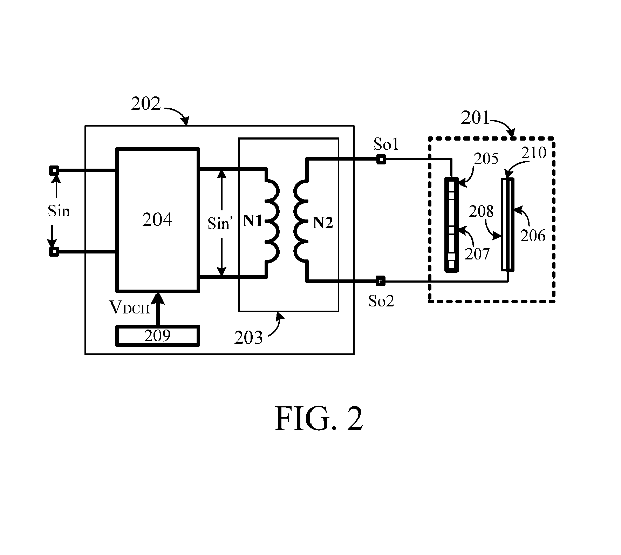

FIG. 2 illustrates an audio driver for flat sound generator system in accordance with one embodiment of the present invention. An audio driver 202 coupled to a capacitance flat sound generator 201 and includes a power amplifier 204 and an audio-amplifying transformer 203 receiving an input audio signal $S_{in}$ and for transforming it into two high voltage output audio signals $S_{o1}$ and $S_{o2}$, wherein the output audio signals $S_{o1}$ and $S_{o2}$ have the same intensity with each other but one is positive high voltage and the other is negative. In one embodiment, the input audio signal $S_{in}$ is the audio signal provided by the portable multi-media device, such as MP3 player, CD player, and smart phone, etc. The power amplifier 204 receives a DC high voltage VDCH provided by a high voltage DC source 209 and amplifies the input audio signal $S_{in}$ to a amplified input audio signal $S_{in}$'. In one embodiment, the DC source 209 is provided by a DC/AC converter (not shown) or DC/DC converter (not shown). The power amplifier 204 can be a class AB amplifier or class D amplifier, but not limited to.

The capacitance flat sound generator 201 includes a perforated electrode plate 205 and a diaphragm 210, wherein the perforated electrode plate 205 includes a plurality of openings 207. The diaphragm 210 includes a film body layer 208 and an electrode layer 206 with charges. In one embodiment, the film body layer 208 can be composed of polytetrafluoroethene(PTFE) or fluorinated ethylene propylene(FEP), but not limited to. In one embodiment, the electrode layer 206 can be composed of aluminum, chromium, or any other electricity conductive materials, but not limited to. The perforated electrode plate 205 and the diaphragm 210 receive the output audio signals $S_{o1}$ and $S_{o2}$ respectively.

The capacitance flat sound generator 201 can be used as a capacitor, wherein the capacitance C can be represented according to equation (1):

$$C = \varepsilon_o \varepsilon_r \frac{A}{d} \qquad (1)$$

Wherein, in equation (1), $\varepsilon_0$ is a dielectric factor of vacuum, $\varepsilon_r$ is a relatively dielectric factor, A is the measure of area of the diaphragm 210 and the perforated electrode plate 205, d is the distance between the diaphragm 210 and the perforated electrode plate 205.

The amplified input audio signal $S_{in}$' be amplified $N_2/N_1$ times by the audio-amplifying transformer 203 and be transformed as output audio signals $S_{o1}$ and $S_{o2}$ to drive the capacitance flat sound generator 201. The value of the output audio signals $S_{o1}$ and $S_{o2}$ can be represented according to equation (2) or equation (3):

$$S_{O1} = S_{in}'\frac{N_2}{N_1} + V_{DCH} \quad , \quad S_{O2} = S_{in}'\frac{N_2}{N_1} - V_{DCH} \qquad (2)$$

$$S_{O1} = S_{in}'\frac{N_2}{N_1} - V_{DCH} \quad , \quad S_{O2} = S_{in}'\frac{N_2}{N_1} + V_{DCH} \qquad (3)$$

In one embodiment, the ratio ($N_2/N_1$) of the secondary winding and the primary winding of the audio-amplifying transformer 203 is around 50~120. In another embodiment, the windings of the primary side or the secondary side are enameled wire with $0.12\phi$~$0.02\phi$.

The power consumption $W_c$ of the capacitance flat sound generator 201 can be represented according to equation (4):

$$W_C = \frac{1}{2}C(S_{o1} - S_{o2})^2 \qquad (4)$$

Although the difference ($S_{o1}$-$S_{o2}$) between the output audio signals $S_{o1}$ and $S_{o2}$ is large, the capacitance of the capacitance flat sound generator 201 is very small (usually around 20pF~20nF). Thus, the level of the power consumption $W_c$ of the capacitance flat sound generator 201 is around uW.

Advantageously, the audio-amplifying transformer 203 and the capacitance flat sound generator 201 form a low-pass filter for filtering out the high frequency signal which outputted to the output audio signals $S_{o1}$ and $S_{o2}$. Further, the audio-amplifying transformer 203 is modulated between a wideband of the input audio signal $S_{in}$ which has relatively high frequency, thus, the capacitance flat sound generator 201 just need a low cost transformer with higher central frequency instead of the high power transformer which with low wideband. As a result, the volume and the weight of the capacitance flat sound generator 201 can be reduced and further decrease the power consumption and then to improve the working time of the portable electronic device.

In one embodiment, the silicon steel of the audio-amplifying transformer 203 has characteristics of low frequency, directivity, and high permeability. In another embodiment, the material of the bobbin of the audio-amplifying transformer 203 is liquid crystal plastic(LCP) and the pin type is C type, so as to avoid the diameter of the winding of the primary side or the secondary side too thin and cause the disconnection.

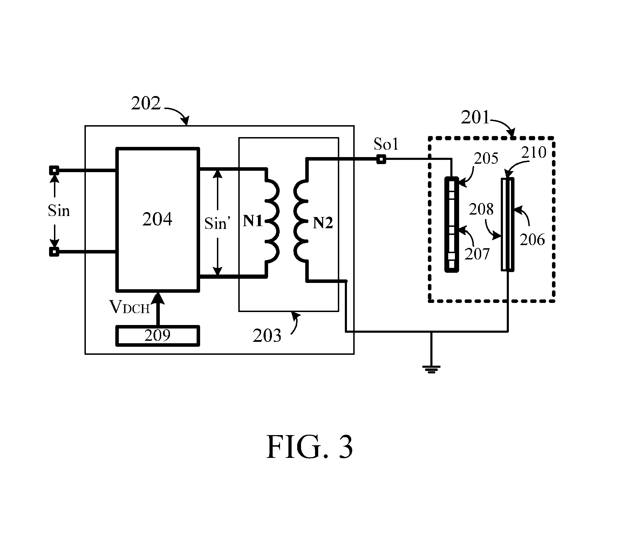

FIG. 3 illustrates an audio driver for flat sound generator system in accordance with another embodiment of the present invention. Elements that are labeled the same as in FIG. 2 have similar functions. The difference between FIG.2 and FIG. 3 is that the output audio signal $S_{o2}$ coupled to one end of the diaphragm 210 and grounded so as to form another audio driver for flat sound generator. The working concept and the characteristic shown in FIG. 3 are as same as the embodiment shown in FIG. 2 and will be described in detail as below.

An audio driver 202 coupled to a capacitance flat sound generator 201 and includes a power amplifier 204 and an audio-amplifying transformer 203 receiving an input audio signal $S_{in}$ and for transforming it into a high voltage output audio signals $S_{o1}$. In one embodiment, the input audio signal $S_{in}$ is the audio signal provided by the portable multi-media device, such as MP3 player, CD player, and smart phone, etc. The power amplifier 204 receives a DC high voltage VDCH provided by a high voltage DC source 209 and amplifies the input audio signal $S_{in}$ to a amplified input audio signal $S_{in}$'. In one embodiment, the DC source 209 is provided by a DC/AC converter (not shown) or DC/DC converter (not shown). The power amplifier 204 can be a class AB amplifier or class D amplifier, but not limited to.

The capacitance flat sound generator 201 includes a perforated electrode plate 205 and a diaphragm 210, wherein the perforated electrode plate 205 includes a plurality of openings 207. The diaphragm 210 includes a film body layer 208 and an electrode layer 206 with charges. In one embodiment, the film body layer 208 can be composed of polytetrafluoroethene(PTFE) or fluorinated ethylene propylene(FEP), but not limited to. In one embodiment, the electrode layer 206 can be composed of aluminum, chromium, or any other electricity conductive materials, but not limited to. The perforated electrode plate 205 and the diaphragm 210 receive the output audio signal $S_{o1}$.

The capacitance flat sound generator 201 can be used as a capacitor, wherein the capacitance C can be represented according to equation (5):

$$C = \varepsilon_o \varepsilon_r \frac{A}{d} \qquad (5)$$

Wherein, in equation (5), $\varepsilon_0$ is a dielectric factor of vacuum, $\varepsilon_r$ is a relatively dielectric factor, A is the measure of area of the diaphragm 210 and the perforated electrode plate 205, d is the distance between the diaphragm 210 and the perforated electrode plate 205.

The amplified input audio signal $S_{in}$' be amplified $N_2/N_1$ times by the audio-amplifying transformer 203 and be transformed as a output audio signals $S_{o1}$ to drive the capacitance flat sound generator 201. The value of the output audio signal $S_{o1}$ can be represented according to equation (6) or equation (7):

$$S_{O1} = S_{in}\,'\frac{N_2}{N_1} + V_{DCH} \qquad (6)$$

$$S_{O1} = S_{in}\,'\frac{N_2}{N_1} - V_{DCH} \qquad (7)$$

In one embodiment, the ratio ($N_2/N_1$) of the secondary winding and the primary winding of the audio-amplifying transformer 203 is around 50~120. In another embodiment, the windings of the primary side or the secondary side are enameled wire with $0.12\phi{\sim}0.02\phi$.

The power consumption $W_c$ of the capacitance flat sound generator 201 can be represented according to equation (8):

$$W_C = \frac{1}{2}CS_{o1}{}^2 \qquad (4)$$

Although the vaule of $S_{o1}$ is large, the capacitance of the capacitance flat sound generator 201 is very small (usually around 20pF~20nF). Thus, the level of the power consumption $W_c$ of the capacitance flat sound generator 201 is around uW.

Advantageously, the audio-amplifying transformer 203 and the capacitance flat sound generator 201 form a low-pass filter for filtering out the high frequency signal which outputted to the output audio signal $S_{o1}$. Further, the audio-amplifying transformer 203 is modulated between a wideband of the input audio signal $S_{in}$ which has relatively high frequency, thus, the capacitance flat sound generator 201 just need a low cost transformer with higher central frequency instead of the high power transformer which with low wideband. As a result, the volume and the weight of the capacitance flat sound generator 201 can be reduced and further decrease the power consumption and then to improve the working time of the portable electronic device.

In one embodiment, the silicon steel of the audio-amplifying transformer 203 has characteristics of low frequency, directivity, and high permeability. In another embodiment, the material of the bobbin of the audio-amplifying transformer 203 is liquid crystal plastic(LCP) and the pin type is C type, so as to avoid the diameter of the winding of the primary side or the secondary side too thin and cause the disconnection.

While the foregoing description and drawings represent embodiments of the present invention, it will be understood that various additions, modifications and substitutions may be made therein without departing from the spirit and scope of the principles of the present invention as defined in the accompanying claims. One skilled in the art will appreciate that the invention may be used with many modifications of form, structure, arrangement, proportions, materials, elements, and components and otherwise, used in the practice of the invention, which are particularly adapted to specific environments and operative requirements without departing from the principles of the present invention. The presently disclosed embodiments are therefore to be considered in all respects as illustrative and not restrictive, the scope of the invention being indicated by the appended claims and their legal equivalents, and not limited to the foregoing description.

## Claims

1. An audio driver for a flat sound generator, wherein said audio driver coupled to said flat sound generator and said flat sound generator comprising a perforated electrode plate and a diaphragm, wherein said audio driver comprising:

   a power amplifier operable for receiving an input audio signal and for transforming said input audio signal into an amplified input audio signal; and
   an audio-amplifying transformer operable for receiving said amplified input audio signal and for transforming said amplified input audio signal into two output audio signals with high voltage, wherein said output audio signals are coupled to said perforated electrode plate and said diaphragm respectively;

wherein, said audio-amplifying transformer and said flat sound generator form a low-pass filter effectively.

2. The audio driver of claim 1, further comprising an AC/DC converter or a DC/DC converter operable for providing a high DC voltage to said power amplifier.

3. The audio driver of claim 1, wherein said power amplifier is a class AB amplifier or a class D amplifier.

4. The audio driver of claim 1, wherein said input audio signal is provided by a MP3 player, a CD player, or a smart phone.

5. The audio driver of claim 1, wherein said diaphragm includes a film body layer and an electrode layer with charges.

6. An audio driver for a flat sound generator, wherein said audio driver coupled to said flat sound generator and said flat sound generator comprising a perforated electrode plate and a diaphragm, said audio driver comprising:

a power amplifier operable for receiving an input audio signal and for transforming said input audio signal into an amplified input audio signal; and

an audio-amplifying transformer operable for receiving said amplified input audio signal and for transforming said amplified input audio signal into an output audio signal with high voltage, wherein said output audio signal is coupled to said perforated electrode plate and said diaphragm grounded;

wherein, said audio-amplifying transformer and said flat sound generator form a low-pass filter effectively.

7. The audio driver of claim 6, further comprising an AC/DC converter or a DC/DC converter operable for providing a high DC voltage to said power amplifier.

8. The audio driver of claim 6, wherein said power amplifier is a class AB amplifier or a class D amplifier.

9. The audio driver of claim 6, wherein said input audio signal is provided by a MP3 player, a CD player, or a smart phone.

10. The audio driver of claim 6, wherein said diaphragm includes a film body layer and an electrode layer with charges.

**FIG.1   PRIOR ART**

FIG. 2

FIG. 3

Europäisches
Patentamt
European
Patent Office
Office européen
des brevets

**EUROPEAN SEARCH REPORT**

Application Number

EP 11 16 1836

| | DOCUMENTS CONSIDERED TO BE RELEVANT | | |
|---|---|---|---|
| Category | Citation of document with indication, where appropriate, of relevant passages | Relevant to claim | CLASSIFICATION OF THE APPLICATION (IPC) |
| X | GB 1 234 767 A (DECCA LTD [GB]) 9 June 1971 (1971-06-09) * page 2, line 48 - line 57; figure 3 * | 1-10 | INV. H03F3/20 H04R19/02 |
| X | GB 1 353 098 A (PIONEER ELECTRONIC CORP) 15 May 1974 (1974-05-15) * page 2, line 14 - line 45; figure 2 * | 1-10 | |
| X | US 3 894 198 A (MURAYAMA HAOHIRO ET AL) 8 July 1975 (1975-07-08) * column 3, line 22 - column 4, line 33; figures 4, 4A, 4B * | 1-10 | |
| A | US 5 748 758 A (MENASCO JR LAWRENCE C [US] ET AL) 5 May 1998 (1998-05-05) * column 7, line 21 - line 37; figure 2 * | 1-10 | |
| A | BAI MINGSIAN ET AL: "Electroacoustic analysis of an electret loudspeaker using combined finite-element and lumped-parameter models", THE JOURNAL OF THE ACOUSTICAL SOCIETY OF AMERICA, AMERICAN INSTITUTE OF PHYSICS FOR THE ACOUSTICAL SOCIETY OF AMERICA, NEW YORK, NY, US, vol. 125, no. 6, 1 June 2009 (2009-06-01), pages 3632-3640, XP012123307, ISSN: 0001-4966, DOI: 10.1121/1.3117377 * the whole document * | 1-10 | TECHNICAL FIELDS SEARCHED (IPC) H03F H04R |

The present search report has been drawn up for all claims

| Place of search | Date of completion of the search | Examiner |
|---|---|---|
| Munich | 8 September 2011 | Lorenzo, Carlos |

## ANNEX TO THE EUROPEAN SEARCH REPORT
## ON EUROPEAN PATENT APPLICATION NO.

EP 11 16 1836

This annex lists the patent family members relating to the patent documents cited in the above-mentioned European search report.
The members are as contained in the European Patent Office EDP file on
The European Patent Office is in no way liable for these particulars which are merely given for the purpose of information.

08-09-2011

| Patent document cited in search report | | Publication date | Patent family member(s) | | Publication date |
|---|---|---|---|---|---|
| GB 1234767 | A | 09-06-1971 | NONE | | |
| GB 1353098 | A | 15-05-1974 | CA | 949675 A1 | 18-06-1974 |
| | | | DE | 2134661 A1 | 10-02-1972 |
| | | | FR | 2100905 A1 | 24-03-1972 |
| | | | JP | 49000063 B | 05-01-1974 |
| | | | ZA | 7104259 A | 29-03-1972 |
| US 3894198 | A | 08-07-1975 | CA | 989972 A1 | 25-05-1976 |
| | | | DE | 2253721 A1 | 24-05-1973 |
| | | | FR | 2158571 A1 | 15-06-1973 |
| | | | GB | 1405789 A | 10-09-1975 |
| | | | JP | 48053713 A | 28-07-1973 |
| | | | JP | 52021364 B | 10-06-1977 |
| | | | NL | 7214888 A | 08-05-1973 |
| US 5748758 | A | 05-05-1998 | NONE | | |

For more details about this annex : see Official Journal of the European Patent Office, No. 12/82